# EUROPEAN PATENT APPLICATION

(11) **EP 2 810 997 A1**
(43) Date of publication of application: **10.12.2014**
(21) Application number: 13170661.6
(22) Date of filing: 05.06.2013
(51) Int. Cl.: C09G 1/02, B24B 37/04, H01L 21/306, H01L 21/02

(54) **A chemical mechanical polishing (cmp) composition**

(71) Applicant: BASF SE, 67056 Ludwigshafen (DE)
(72) Inventor: Noller, Bastian Marten, 64653 Lorsch (DE); Six, Manuel, 68766 Hockenheim (DE)

(57) **Abstract**

A chemical mechanical polishing (CMP) composition (Q) consisting essentially of
(A) aluminum particles in an amount of from 0.01 to 3 wt.% based on the total weight of the CMP composition
(B) at least one oxidizer,
(M) an aqueous medium and
(N) optionally at least one pH adjusting agent
wherein the CMP composition (Q) has a pH of from 2 to 6.

## Description

This invention is in the field of chemical mechanical polishing (also abbreviated as CMP in the following). More specifically it relates to a CMP composition for the polishing of germanium comprising substrates.

In the semiconductor industry, chemical mechanical polishing is a well-known technology applied in fabricating advanced photonic, microelectromechanical, and microelectronic materials and devices, such as semiconductor wafers.

During the fabrication of materials and devices used in the semiconductor industry, CMP is employed to planarize metal and/or oxide surfaces. CMP utilizes the interplay of chemical and mechanical action to achieve the planarity of the to-be-polished surfaces. Chemical action is provided by a chemical composition, also referred to as CMP composition or CMP slurry. Mechanical action is usually carried out by a polishing pad which is typically pressed onto the to-be-polished surface and mounted on a moveable platen. During the polishing action the platen is moved. The movement of the platen is usually linear, rotational or orbital.

In a typical CMP process step, a rotating wafer holder brings the to-be-polished wafer in contact with a polishing pad. The CMP composition is usually applied between the to-be-polished wafer and the polishing pad.

In the state of the art, CMP compositions comprising abrasive particles and oxidizer, wherein the CMP compositions have an acidic pH and were used for the polishing of metal containing surfaces are known and described for instance, in the following references.

US 7,678,605 B2 discloses a method for chemical mechanical planarization of a surface having at least one feature thereon comprising a chalcogenide material. The polishing composition as disclosed comprises an abrasive and an oxidizing agent.

US 7,915,071 B2 discloses a method for chemical mechanical planarization of a surface having at least one feature thereon comprising a chalcogenide material. The polishing composition as disclosed comprises a surface-modified abrasive having a positive zeta potential and an oxidizing agent.

US 7,897,061 B2 discloses a chemical-mechanical polishing (CMP) composition for polishing a phase change alloy-containing substrate. Said composition comprises a particulate abrasive material in an amount of not more than about three percent by weight and at least one chelating agent.

WO 2013/018015 discloses a process for the manufacture of semiconductor devices comprising the chemical mechanical polishing of elemental germanium and/or Si₁₋ₓGeₓ material in the presence of a chemical mechanical polishing (CMP) composition which comprises inorganic particles, organic particles, or a mixture or composite thereof. In addition to an oxidizing agent at least one type of an organic compound is comprised.

WO 2013/018016 discloses a process for the manufacture of semiconductor devices comprising the chemical mechanical polishing of elemental germanium and/or Si₁₋ₓGeₓ material in the presence of a chemical mechanical polishing (CMP) composition having a pH value in the range of from 3.0 to 5.5. In addition to silica particles hydrogen peroxide as oxidizing agent is comprised in the examples.

One of the objects of the present invention was to provide a CMP composition. In particular a CMP composition was sought showing an improved polishing performance, especially
(i) a high material removal rate (MRR) of the substrate to be preferably polished, for example elemental germanium
(ii) a high selectivity of germanium and/or Si₁₋ₓGeₓ to silicon dioxide (Ge and/or Si₁₋ₓGeₓ:SiO₂ selectivity)
(iii) a low static etching rate (SER) of germanium and/or Si₁₋ₓGeₓ,
(iv) the combination of (i), (ii), (iii).

Furthermore, a CMP composition was aimed at which is a stable formulation or dispersion.

A further object of the present invention was to provide a CMP process appropriate for the chemical-mechanical polishing of substrates comprising elemental germanium or Si₁₋ₓGeₓ with 0.1 ≤x<1.

Moreover, a CMP process was sought that is easy to apply and requires as few steps as possible.

Accordingly, a chemical mechanical polishing (CMP) composition (Q) was found consisting essentially of
(A) aluminum particles in an amount of from 0.01 to 3 wt.% based on the total weight of the CMP composition
(B) at least one oxidizer
(M) an aqueous medium and
(N) optionally at least one pH adjusting agent
   wherein the CMP composition has a pH of from 2 to 6.

In addition, a process for the preparation of the CMP composition (Q) comprising, combining (A) 0.01 to 3 wt. % based on the total weight of the CMP composition aluminum particles, (B) at least one oxidizer and (M) an aqueous medium and adjusting the pH value to 2 to 6, thereby optionally employing a pH adjusting agent was found.

Moreover, the use of the CMP composition (Q) for polishing substrates (S) which are used in the semiconductor industry was found, which fulfills the objects of the invention.

Further, a process for the manufacture of a semiconductor device comprising the chemical-mechanical polishing of a substrate in the presence of the CMP composition (Q) was found, which fulfills the objects of the invention.

Preferred embodiments are explained in the claims and the specification. It is understood that combinations of preferred embodiments are within the scope of the present invention.

According to the invention the CMP composition (Q) consists essentially of the components (A), (B),(M) and optionally (N) as described below.

The CMP composition (Q) according to the invention is additive free meaning in the context of the invention that no additives like chelating agents, corrosion inhibitors or surfactants are needed to achieve the described polishing performance.

Component (A) which is contained in (Q) according to the invention can be one type of aluminum particles or a mixture or composite of different types of aluminum particles.

A composite aluminum particle is a particle comprising two or more types of aluminum particles in such a way that they are mechanically, chemically or in another way bound to each other. An example for such a composite aluminum particle is a core-shell particle comprising one type of aluminum particle in the outer sphere (shell) and another type of aluminum particle in the inner sphere (core).

In general various types of aluminum particles can be contained.

The chemical nature of the aluminum particles is not particularly limited. The aluminum particles may be of the same chemical nature or a mixture or composite of particles of different chemical nature. As a rule, aluminum particles of the same chemical nature are preferred.

Preferred are aluminum oxides, aluminum hydroxides, aluminum chloride or a mixture or composite thereof. More preferably alpha aluminum oxide, gamma aluminum oxide, theta aluminum oxide, delta aluminum oxide, fumed aluminum oxide, pyrogenic aluminum oxide, aluminum hydroxide or a mixture or composites thereof. Most preferred are theta aluminum oxide, delta aluminum oxide, fumed aluminum oxide or a mixture or composite thereof, in particular fumed aluminum oxide.

Preferably the aluminum particles comprise at least 85 wt.% (wt.% stands for "percent by weight") of aluminum oxide (Al₂O₃). More preferably, the amount of aluminum oxide of the aluminum particles is at least 88 wt.%, most preferably at least 90 wt. %, particularly preferably at least 92 wt. %, in particular at least 95 wt. %, for example at least 98 wt. %, at least 99 wt. % or at least 99.5 wt. %.

The aluminum particles can be of various shapes. Thereby, the aluminum particles may be of one or essentially only one type of shape. However, it is also possible that the aluminum particles have different shapes. For instance, two types of differently shaped aluminum particles may be present. For example, the aluminum particles can have the shape of cubes, cubes with chamfered edges, octahedrons, icosahedrons, cocoons, nodules or spheres with or without protrusions or indentations. Preferably, they are essentially spherical, whereby typically these have protrusions or indentations.

The BET surface determined according to DIN ISO 9277 of the aluminum particles can vary within a wide range. Preferably, the BET surface of the aluminum particles is in the range of from 1 to 500 m²/g, more preferably in the range of from 5 to 250 m²/g, most preferably in the range of from 10 to 100 m²/g, in particular in the range of from 20 to 90 m²/g, for example in the range of from 25 to 85 m²/g.

Generally, the aluminum particles can be contained in various particle size distributions. The particle size distribution of the aluminum particles can be monomodal or multimodal. In case of multimodal particle size distribution, bimodal is often preferred. In order to have an easily reproducible property profile and easily reproducible conditions during the CMP process of the invention, a monomodal particle size distribution is preferred. It is most preferred for the aluminum particles to have a monomodal particle size distribution.

The mean particle size of the aluminum particles can vary within a wide range. The mean particle size is the d₅₀ value of the particle size distribution of the aluminum particles in the aqueous medium (M) and can be determined using static light scattering techniques. Then, the d₅₀ value is calculated under the assumption that the aluminum particles are essentially spherical. The width of the mean particle size distribution is the distance (given in units of the x-axis) between the two intersection points, where the particle size distribution curve crosses the 50 % height of the relative particle counts, wherein the height of the maximal particle counts is standardized as 100% height.

Preferably, the mean particle size of the aluminum particles is in the range of from 1 to 500 nm, more preferably in the range of from 5 to 300 nm, most preferably in the range of from 10 to 200 nm, in particular in the range of from 20 to 150 nm, for example in the range of from 25 to 120 nm, as measured with static light scattering technique.

It is for instance possible that aluminum particles of different chemical nature having the same shape and / or BET range and / or particle size distribution are contained. It is also possible that e.g. aluminum particles of the same chemical nature differing in shape and / or BET range and / or particle size distribution are contained. It is preferred that uniform or essentially uniform aluminum particles are contained that is to say aluminum particles of the same chemical nature, BET range and particles size distribution in the ranges listed above.

According to the invention the amount of (A) is not more than 3 wt.%, more preferably not more than 2.6 wt.%, most preferably not more than 2.2 wt.%, particularly not more than 2.0 wt.%, based on the total weight of the composition (Q). Preferably, the amount of (A) is at least 0.01 wt.%, more preferably at least 0.02 wt.%, most preferably at least 0.03 wt.%, particularly at least 0.04 wt.%, based on the total weight of the composition (Q). For example the amount of (A) can be in the range of from 0.05 wt.% to 2.1 wt.%.

Particularly well suited aluminum oxide nanoparticles for the composition are stable in the pH range of 3 to 5. More precisely this includes aluminum oxide nanoparticles with a positive zeta potential in the range of pH 3 to 5.

In general aluminum particles can be produced using different production processes generally known to a person skilled in the art. Typically, fumed aluminum particles are produced by high temperature flame hydrolysis of aluminum-(III)-chloride with hydrogen in the presence of oxygen, for example using the Aerosil^{®} process.

A further component (B) of the CMP composition (Q) according to the invention is at least one oxidizer that is to say one type or a mixture of different types of oxidizers. Generally, an oxidizer is a compound which is capable of oxidizing the to-be-polished substrate or surface or anyone of its layers. In general, any oxidizer can be used.

Preferably component (B) is one or two types of oxidizer, more preferably one type of oxidizer. Preferably, component (B) is a per-type oxidizer such as an organic or inorganic per-type oxidizer or a mixture of per-type oxidizers, most preferably one per-type oxidizer. More preferably, (B) is an inorganic per-type oxidizer, in particular a peroxide, persulfate, perchlorate, perbromate, periodate, permanganate, a derivative thereof or a mixture of two or more thereof. Most preferably, (B) is a peroxide or persulfate. Particularly, (B) is a peroxide. In particular, (B) is hydrogen peroxide.

Component (B) can be contained in various amounts in the CMP composition (Q). Preferably, the amount of (B) is not more than 20 wt.%, more preferably not more than 10 wt.%, most preferably not more than 5 wt.%, particularly not more than 3.0 wt.%, based on the total weight of the composition (Q). Preferably, the amount of (B) is at least 0.01 wt.%, more preferably at least 0.08 wt.%, most preferably at least 0.1 wt.%, particularly at least 0.2 wt.%, such as of from 0.3 to 1.5 wt.% based on the total weight of the composition (Q). If hydrogen peroxide is used as oxidizer (B), the amount of (B) is preferably 0.1 wt.% to 4 wt.%, more preferably 0.2 wt.% to 3 wt.%, for instance 0.5 to 1.0 wt.%, based on the total weight of the composition (Q).

A further component (M) of the CMP composition (Q) according to the invention is an aqueous medium. (M) can be of one type or a mixture of different types of aqueous media.

In general, the aqueous medium (M) can be any medium which contains water. Preferably, the aqueous medium (M) is a mixture of water and an organic solvent miscible with water (e.g. an alcohol, preferably a C₁ to C₃ alcohol, or an alkylene glycol derivative). More preferably, the aqueous medium (M) is water. Most preferably, aqueous medium (M) is deionized water.

If the amounts of the components other than (M) are in total y wt.% of the CMP composition, then the amount of (M) is (100-y) wt.% of the CMP composition.

The aqueous medium (M) can be contained in various amounts in the CMP composition (Q). Preferably, the amount of (M) is not more than 99.8 wt.%, more preferably not more than 99.6 wt.%, most preferably not more than 99 wt.%, particularly preferably not more than 98 wt.%, particularly not more than 97 wt.%, for example not more than 95 wt.%, based on the total weight of the composition (Q). Preferably, the amount of (M) is at least 60 wt.%, more preferably at least 70 wt.%, most preferably at least 80 wt.%, particularly preferably at least 85 wt.%, particularly at least 90 wt.%, for example at least 93 wt.%, based on the total weight of the composition (Q).

The properties of the CMP composition (Q), such as stability and polishing performance, may depend on the pH of the corresponding composition.

The pH value of the composition (Q) is according to the invention not more than 6, more preferably not more than 5.8, most preferably not more than 5.5, particularly preferably not more than 5.4, particularly most preferably not more than 5.3, particularly not more than 5.2. The pH value of the composition (Q) is according to the invention at least 2, more preferably at least 2.2, most preferably at least 2.5, particularly preferably at least 2.7, particularly most preferably at least 2.8, particularly at least 2.9. The pH value of the composition (Q) is preferably in the range of from 2 to 6, more preferably from 2.2 to 5.8, most preferably from 2.5 to 5.5, particularly preferably from 2.7 to 5.4, particularly most preferably from 2.8 to 5.3, particularly from 2.9 to 5.2, for example from 3 to 5.

The CMP composition (Q) can further optionally contain at least one pH adjusting agent (N) in an amount of from 0 to 2 wt.% based on the total weight of the CMP composition (Q). The pH adjusting agent (N) is different from the components (A), (B) and (M). In general, the pH adjusting agent (N) is a compound which is added to the CMP composition (Q) to have its pH value adjusted to the required value. Preferably, the CMP composition (Q) contains at least one pH adjusting agent (N). Preferred pH adjusting agents are inorganic acids, carboxylic acids, amine bases, alkali hydroxides, ammonium hydroxides, including tetraalkylammonium hydroxides. Particularly, the pH adjusting agent (N) is nitric acid, sulfuric acid, ammonia, sodium hydroxide, or potassium hydroxide. For example, the pH adjusting agent (N) is potassium hydroxide or nitric acid.

If present, the pH adjusting agent (N) can be contained in various amounts. If present, the amount of (N) is preferably not more than 2 wt.%, more preferably not more than 1 wt.%, most preferably not more than 0.5 wt.%, particularly not more than 0.1 wt.%, for example not more than 0.05 wt.%, based on the total weight of the CMP composition (Q). If present, the amount of (N) is preferably at least 0.0005 wt.%, more preferably at least 0.005 wt.%, most preferably at least 0.025 wt.%, particularly at least 0.1 wt.%, for example at least 0.4 wt.%, based on the total weight of the corresponding composition (Q).

Compositions Q which according to the invention are preferred essentially consist of:
(A1) aluminum oxide particles,
(B1) a inorganic peroxide
(M1) an aqueous medium
(A2) fumed aluminum oxide particles,
(B2) hydrogen peroxide
(N2) a pH adjusting agent
(M2) water
(A3) aluminum oxide particles in an amount of from 0.01 to 3 wt. % based on the total weight of the CMP composition,
(B3) hydrogen peroxide in an amount of from 0.01 to 5 wt.% based on the total weight of the CMP composition
(M3) water in an amount of from 90 to 99.8 wt.% based on the total weight of the CMP composition
(N3) one pH adjusting agent in an amount of from 0 to 2 wt.% based on the total weight of the CMP composition
(A4) fumed aluminum oxide particles in an amount of from 0.03 to 2.1 wt. % based on the total weight of the CMP composition,
(B4) hydrogen peroxide in an amount of from 0.5 to 1.5 wt.% based on the total weight of the CMP composition
(M4) water in an amount of from 95.4 to 99.4 wt.% based on the total weight of the CMP composition.
(N4) one pH adjusting agent in an amount of from 0.07 to 1 wt.% based on the total weight of the CMP composition
(A5) fumed aluminum oxide particles in an amount of from 0.05 to 1.8 wt. % based on the total weight of the CMP composition,
(B5) hydrogen peroxide in an amount of from 0.5 to 1 wt.% based on the total weight of the CMP composition
(M5) water in an amount of from 96.7 to 99.4 wt.% based on the total weight of the CMP composition.
(N5) one pH adjusting agent in an amount of from 0.05 to 0.5 wt.% based on the total weight of the CMP composition

A semiconductor device can be manufactured by the process of the invention, said process comprises the chemical mechanical polishing of elemental germanium and/or Si₁₋ₓGeₓ material (with 0.1 ≤ x < 1) in the presence of the CMP composition (Q), preferably, said process comprises the chemical mechanical polishing of elemental germanium and/or Si₁₋ₓGeₓ in the presence of the CMP composition (Q).

Generally, the semiconductor device which can be manufactured by the process according to the invention is not particularly limited. Thus the semiconductor devices can be an electronic component comprising semiconducting materials, as for example silicon, germanium, and Ill-V materials. Semiconductor devices can be those which are manufactured as single discrete devices or those which are manufactured as integrated circuits (ICs) consisting of a number of devices manufactured and interconnected on a wafer. Semiconductor devices can be two terminal devices for example a diode, three terminal devices for example a bipolar transistor, four terminal devices for example a Hall effect sensor or multi-terminal devices. Preferably, said semiconductor device is a multi-terminal device. Multi-terminal devices can be logic devices as integrated circuits and microprocessors or memory devices as random access memory (RAM), read only memory (ROM) and phase change random access memory (PCRAM). Preferably said semiconductor device is a multi-terminal logic device. In particular said semiconductor device is an integrated circuit or microprocessor.

Generally, this elemental germanium and/or Si₁₋ₓGeₓ can be of any type, form, or shape of elemental germanium and/or Si₁₋ₓGeₓ. This elemental germanium and/or Si₁₋ₓGeₓ preferably has the shape of a layer and/or overgrowth. If this elemental germanium and/or Si₁₋ₓGeₓ has the shape of a layer and/or overgrowth, the germanium and/or Si₁₋ₓGeₓ content is preferably more than 90%, more preferably more than 95%, most preferably more than 98%, particularly more than 99%, for example more than 99.9% by weight of the corresponding layer and/or overgrowth. Generally, this elemental germanium and/or Si₁₋ₓGeₓ can be produced or obtained in different ways. This elemental germanium and/or Si₁₋ₓGeₓ has been preferably filled or grown in trenches between other substrates, more preferably filled or grown in trenches between silicon dioxide, silicon, or other isolating and semiconducting material used in the semiconductor industry, most preferably filled or grown in trenches between the STI (shallow-trench isolation) silicon dioxide, particularly grown in trenches between the STI silicon dioxide in a selective epitaxial growth process. If this elemental germanium and/or Si₁₋ₓGeₓ has been filled or grown in trenches between the STI silicon dioxide, the depth of said trenches is preferably from 20 to 500 nm, more preferably from 150 to 400 nm, and most preferably from 250 to 350 nm, particularly from 280 to 320 nm. In another embodiment, if this elemental germanium and/or Si₁₋ₓGeₓ has been filled or grown in trenches between silicon dioxide, silicon, or other isolating and semiconducting material used in the semiconductor industry, the depth of said trenches is preferably from 5 to 100 nm, more preferably from 8 to 50 nm, and most preferably from 10 to 35 nm, particularly from 15 to 25 nm.

Elemental germanium is germanium in form of its chemical element and preferably does not include germanium salts or germanium alloys with a content of less than 90% germanium by weight of the corresponding alloy.

Said Si₁₋ₓGeₓ material (with 0.1 ≤ x < 1) can be of any type, form, or shape of Si₁₋ₓGeₓ material with 0.1 ≤ x < 1. Generally, x can be any value in the range of 0.1 ≤ x < 1. Preferably, x is in the range of 0.1 ≤ x < 0.8, more preferably, x is in the range of 0.1 ≤ x < 0.5, most preferably, x is in the range of 0.1 ≤ x < 0.3, for example x is 0.2. Said Si₁₋ₓGeₓ material is preferably a Si₁₋ₓGeₓ layer, more preferably a strain-relaxed Si₁₋ₓGeₓ layer. This strain-relaxed Si₁₋ₓGeₓ layer can be the one described in paragraph [0006] of US 2008/0265375 A1, which is incorporated by reference herewith.

If the process of the invention comprises the chemical mechanical polishing of a substrate comprising elemental germanium and/or Si₁₋ₓGeₓ and silicon dioxide, the selectivity of germanium and/or Si₁₋ₓGeₓ to silicon dioxide with regard to the material removal rate is preferably higher than 10:1, more preferably higher than 20:1, most preferably higher than 30:1, particularly higher than 50:1, especially higher than 75:1, for example higher than 100:1. This selectivity can be adjusted for example by the type and concentration of organic compound (C) of the CMP composition (Q) and by setting other parameters such as the pH value.

The CMP composition (Q) according to the invention is used preferably for chemical-mechanical polishing of a substrate comprising elemental germanium and/or Si₁₋ₓGeₓ material (with 0.1 ≤ x < 1), preferably for chemical-mechanical polishing of a substrate comprising an elemental germanium and/or Si₁₋ₓGeₓ layer and/or overgrowth. The germanium and/or Si₁₋ₓGeₓ content of said elemental germanium and/or Si₁₋ₓGeₓ layer and/or overgrowth is preferably more than 90%, more preferably more than 95%, most preferably more than 98%, particularly more than 99%, for example more than 99.9% by weight of the corresponding layer and/or overgrowth. The elemental germanium and/or Si₁₋ₓGeₓ layer and/or overgrowth can be obtained in different ways, preferably by filling or growing in trenches between other substrates, more preferably by filling or growing in trenches between silicon dioxide, silicon, or other isolating and semiconducting material used in the semiconductor industry, most preferably by filling or growing in trenches between the STI (shallow-trench isolation) silicon dioxide, particularly by growing in trenches between the STI silicon dioxide in a selective epitaxial growth process.

If the CMP composition (Q) according to the invention is used for polishing a substrate comprising elemental germanium and silicon dioxide, the selectivity of germanium and/or Si₁₋ₓGeₓ to silicon dioxide with regard to the material removal rate is preferably higher than 10:1, more preferably higher than 20:1, most preferably higher than 30:1, particularly higher than 50:1, especially higher than 75:1, for example higher than 100:1.

Processes for preparing CMP compositions are generally known. These processes may be applied to the preparation of the CMP composition (Q) according to the invention. This can be carried out by combining, for example dispersing or dissolving the above-described components (A) and (B) in the aqueous medium (M), preferably water, and optionally by adjusting the pH value through adding an acid, a base, a buffer or an pH adjusting agent. For this purpose, customary and standard mixing processes and mixing apparatuses such as agitated vessels, high shear impellers, ultrasonic mixers, homogenizer nozzles or counterflow mixers, can be used.

The CMP composition (Q) is preferably prepared by dispersing the aluminum particles and dissolving the oxidizer (B) in the aqueous medium (M) and adjusting the pH value to 2 to 6.

The polishing process is generally known and can be carried out with the processes and the equipment under the conditions customarily used for the CMP in the fabrication of wafers with integrated circuits. There is no restriction on the equipment with which the polishing process can be carried out.

As is known in the art, typical equipment for the CMP process consists of a rotating platen which is covered with a polishing pad. Also orbital polishers have been used. The wafer is mounted on a carrier or chuck. The side of the wafer being processed is facing the polishing pad (single side polishing process). A retaining ring secures the wafer in the horizontal position.

Below the carrier, the larger diameter platen is also generally horizontally positioned and presents a surface parallel to that of the wafer to be polished. The polishing pad on the platen contacts the wafer surface during the planarization process.

To produce material loss, the wafer is pressed onto the polishing pad. Both the carrier and the platen are usually caused to rotate around their respective shafts extending perpendicular from the carrier and the platen. The rotating carrier shaft may remain fixed in position relative to the rotating platen or may oscillate horizontally relative to the platen. The direction of rotation of the carrier is typically, though not necessarily, the same as that of the platen. The speeds of rotation for the carrier and the platen are generally, though not necessarily, set at different values. During the CMP process of the invention, the CMP composition (Q) is usually applied onto the polishing pad as a continuous stream or in dropwise fashion. Customarily, the temperature of the platen is set at temperatures of from 10 to 70°C.

The load on the wafer can be applied by a flat plate made of steel for example, covered with a soft pad that is often called backing film. If more advanced equipment is being used a flexible membrane that is loaded with air or nitrogen pressure presses the wafer onto the pad. Such a membrane carrier is preferred for low down force processes when a hard polishing pad is used, because the down pressure distribution on the wafer is more uniform compared to that of a carrier with a hard platen design. Carriers with the option to control the pressure distribution on the wafer may also be used according to the invention. They are usually designed with a number of different chambers that can be loaded to a certain degree independently from each other.

For further details explicit reference is made to WO 2004/063301 A1, in particular page 16, paragraph [0036] to page 18, paragraph [0040] in conjunction with the figure 2.

By way of the CMP process of the invention, wafers with integrated circuits comprising a dielectric layer can be obtained which have an excellent functionality.

The CMP composition (Q) according to the invention can be used in the CMP process as ready-to-use slurry, they have a long shelf-life and show a stable particle size distribution over long time. Thus, they are easy to handle and to store. They show an excellent polishing performance, particularly with regard to the combination of high germanium and/or Si₁₋ₓGeₓ MRR and high Ge and/or Si₁₋ₓGeₓ:SiO₂ selectivity and/or the combination of high germanium and/or Si₁-ₓGeₓ MRR and low germanium and/or Si₁₋ₓGeₓ SER.

In particular the CMP composition (Q) according to the invention can be used for the polishing of substrates comprising elemental germanium grown in trenches between the STI (shallow-trench isolation) silicon dioxide or elemental germanium or Si₁₋ₓGeₓ which has the shape of a layer and/or overgrowth and has a germanium and/or Si₁₋ₓGeₓ content of more than 98% by weight of the corresponding layer and/or overgrowth.

Since the amounts of its components are held down to a minimum, the CMP composition (Q) and the CMP process according to the invention can be used or applied in a cost-effective way. The fact that the CMP composition (Q) is additive-free also leads to a simplified way of making the CMP compositions according to the invention.

### Examples and Comparative Examples

The pH value was measured with a pH electrode (Schott, blue line, pH 0-14 / -5...100 °C / 3 mol/L sodium chloride).

Ge-cSER (cold static etching rate of a germanium layer) was determined by dipping 1x1 inch germanium coupon into the corresponding composition for 5 minutes at 25°C and measuring the loss of mass before and after the dipping.

Ge-hSER (hot static etching rate of a germanium layer) was determined by dipping 1x1 inch germanium coupon into the corresponding composition for 5 minutes at 60°C and measuring the loss of mass before and after the dipping.

### Aluminum particles used in the examples (A1.1)

The aluminum oxide particles which were component (A) are of for example Aeroxide^{®}Alu 65 (Evonik Industries AG) type, which are fumed aluminum oxide particles having a typical particle size d₅₀ of 88 nm and a typical surface area of 65 m²/g. However, other aluminum oxide particles such as Nyacol's colloidal alumina AL20DW can also be used.

### Silica particles used in the comparative examples (S)

The silica particles (S) are of for example Nyacol Nexil 125A colloidal silica particles with a typical particle size of 85 nm, surface area of 35 m²/g and a pH prior to adjustment of 2.5-3.0. However, similar results can be obtained with other colloidal silica particles such as FUSO PL-3 for example.

General procedure for the determination of the d₅₀ value of the particle size distribution using static light scattering techniques

Particle size measurements were performed using standard static (SLS) light scattering techniques. From the scattered light of a 633 nm laser going through the sample, a diffraction pattern was recorded. The intensity of the diffraction pattern was compared to a theoretical calculated pattern, resulting from a theoretical size distribution. In an iterative process the theoretical particle size distribution is varied and the resulting theoretical diffraction pattern (Mie Theory) is compared to the experimental pattern. The iterative process is continued until the theoretical diffraction pattern matches the experimental one.

In the experiments a commercial Malvern Mastersizer 2000 was utilized with autodilution sampler. Typically the samples were diluted with water by the factor 100 prior to the measurement. The following parameters were used as basis for the measurements:
Alumina refractivity: 1,76, silica refractivity 1,59, absorption value: 0,0001, viscosity: 1.03 mm²/s.

### General procedure for the CMP experiments

For measuring electrophoretic mobility a standard Zetasizer Nano device from the company Malvern was used. The samples were diluted by a factor of 500 with 10 mmol/l KCl solution before measuring the mobility. The measurements were carried out at 23°C.

For the evaluation on benchtop polisher, the following parameters were chosen:
Powerpro 5000 Bühler. DF = 40 N, Table speed 200 rpm, carrier speed 150 rpm, slurry flow 20 ml/ min, 20 s conditioning, 3 min polishing time, IC1000 pad, diamond conditioner (3M).

The pad is conditioned by several sweeps, before a new type of CMP composition is used for CMP. For the determination of removal rates at least 3 wafers are polished and the data obtained from these experiments are averaged.

The respective CMP composition was stirred in the local supply station.

The germanium and/or Si₁₋ₓGeₓ material removal rates (Ge and/or Si₁₋ₓGeₓ -MRR) for 2 inch discs polished by the CMP composition were determined by difference of weight of the coated wafers or blanket discs before and after CMP, using a Sartorius LA31 0 S scale. The difference of weight can be converted into the difference of film thickness since the density (5.323 g/cm³ for elemental germanium) and the density (3.827 g/cm³ for Si_{0.5}Ge_{0.5}) and the surface area of the polished material are known. Dividing the difference of film thickness by the polishing time provides the values of the material removal rate.

The silicon oxide material removal rates (oxide MRR) for 2 inch discs polished by the CMP composition were determined by difference of weight of the coated wafers or blanket discs before and after CMP, using a Sartorius LA31 0 S scale. The difference of weight can be converted into the difference of film thickness since the density (2.648 g/cm³ for silicon oxide) and the surface area of the polished material are known. Dividing the difference of film thickness by the polishing time provides the values of the material removal rate.

Objective to be polished: elemental germanium and/or Si₁₋ₓGeₓ wafer

Standard procedure for slurry preparation:
The components (A) and (B) - each in the amounts as indicated in Table 1 - were dispersed or dissolved in deionized water. pH is adjusted by adding of aqueous ammonia solution (0.1% - 10%), 10% KOH solution or HNO₃ (0.1 % - 10 %) to the slurry. The pH value is measured with a pH combination electrode (Schott, blue line 22 pH).

An aqueous dispersion containing the components as listed in Table 1, Table 2 and Table 3 was prepared, furnishing the CMP compositions of the examples 1 to 8 and the comparative examples V1 to V3.

The formulation and polishing performance data and of the CMP compositions of the examples 1 to 8 and of the comparative examples V1 to V3 are given in the Table 1, Table 2 and Table 3:

**Table 1: CMP compositions of the example 1 and of the comparative examples V1 to V3, their pH values, Ge-hSER data as well as their Ge-MRR data in the process of chemical-mechanical polishing of 2" unstructured germanium wafers using these compositions, wherein the aqueous medium (M) of the CMP compositions is de-ionized water. The amounts of the components (A), (B), (F) are specified in weight percent (wt.%) by weight of the corresponding CMP composition. If the amounts of the components other than (M) are in total y wt.% of the CMP composition, then the amount of (M) is (100-y) wt.% of the CMP composition.**

| | Comparative Example V1 | Comparative Example V2 | Comparative Example V3 | Example 1 |
|---|---|---|---|---|
| (A) Particles | S | S | A1.1 | A1.1 |
| | Silica | Silica | Alumina | Alumina |
| | 1.5 wt. % | 1.5 wt. % | 1.5 wt. % | 1.5 wt. % |
| (B) Oxidizer | H₂O₂ | H₂O₂ | H₂O₂ | H₂O₂ |
| | 0.75 wt.% | 0.75 wt.% | 0.75 wt.% | 0.75 wt.% |
| Complexing agent | | Hydroxyethyl piperazin 0.1wt% | Hydroxyethyl piperazin 0.1wt% | |
| pH | 4 | 4 | 4 | 4 |
| Ge-MRR in Å/min | 1470 | 2190 | 4174 | 4445 |
| Ge-hSER in Å/min | 315 | 412 | 405 | 333 |
| Ratio MRR to Ge-hSER | 4.7 | 5.3 | 10.3 | 13.4 |

**Table 2: CMP compositions with varying amounts of aluminum particles of the examples 2 to 5, their pH values, their Ge-MRR data in the process of chemical-mechanical polishing of 2" unstructured germanium wafers using these compositions, wherein the aqueous medium (M) of the CMP compositions is de-ionized water. The amounts of the components (A) and (B) are specified in weight percent (wt.%) by weight of the corresponding CMP composition. If the amounts of the components other than (M) are in total y wt.% of the CMP composition, then the amount of (M) is (100-y) wt.% of the CMP composition.**

| | Example 2 | Example 3 | Example 4 | Example 5 |
|---|---|---|---|---|
| (A) Particles | A1.1 | A1.1 | A1.1 | A1.1 |
| | Alumina | Alumina | Alumina | Alumina |
| | 0.75 wt.% | 0.2 wt.% | 0.05 wt.% | 0.01 wt.% |
| (B) Oxidizer | H₂O₂ | H₂O₂ | H₂O₂ | H₂O₂ |
| | 0.75 wt.% | 0.75 wt.% | 0.75 wt.% | 0.75 wt.% |
| pH | 4 | 4 | 4 | 4 |
| Ge-MRR in Å/min | 4655 | 4783 | 5824 | 2751 |

**Table 3: CMP compositions of the example 1 and examples 6 to 8 with different pH values, their Ge-hSER data as well as their Ge-MRR data in the process of chemical-mechanical polishing of 2" unstructured germanium wafers using these compositions, wherein the aqueous medium (M) of the CMP compositions is de-ionized water. The amounts of the components (A) and (B) are specified in weight percent (wt.%) by weight of the corresponding CMP composition. If the amounts of the components other than (M) are in total y wt.% of the CMP composition, then the amount of (M) is (100-y) wt.% of the CMP composition.**

| | Example 6 | Example 1 | Example 7 | Example 8 |
|---|---|---|---|---|
| (A) Particles | A1.1 | A1.1 | A1.1 | A1.1 |
| | Alumina | Alumina | Alumina | Alumina |
| | 1.5 wt.% | 1.5 wt. % | 1.5 wt. % | 1.5 wt. % |
| (B) Oxidizer | H₂O₂ | H₂O₂ | H₂O₂ | H₂O₂ |
| | 0.75 wt.% | 0.75 wt.% | 0.75 wt. % | 0.75 wt.% |
| pH | 3 | 4 | 5 | 8 |
| Ge-MRR in Å/min | 3422 | 4445 | 2762 | 1030 |
| Ge-hSER in Å/min | 255 | 333 | 921 | 1 |
| Ratio MRR to Ge-hSER | 13.4 | 13.4 | 3 | 1030 |

The examples 1 to 8 according to the invention did not contain additives. The CMP processes of the invention using these examples of CMP compositions show an improved polishing performance. Surprisingly the CMP compositions according to the invention with low aluminum particle concentrations and without additional additives like for example complexing agents are leading to very high Ge - MRR in acidic aqueous medium.

## Claims

1. A chemical mechanical polishing (CMP) composition (Q) consisting essentially of
(A) aluminum particles in an amount of from 0.01 to 3 wt.% based on the total weight of the CMP composition
(B) at least one oxidizer,
(M) an aqueous medium and
(N) optionally at least one pH adjusting agent
wherein the CMP composition (Q) has a pH of from 2 to 6.

2. The CMP composition (Q) according to claim 1, wherein the aluminum particles comprise fumed aluminum oxide.

3. The CMP composition (Q) according to anyone of claims 1 to 2, wherein the aluminum particles comprise at least 95 wt. % of aluminum oxide (Al₂O₃).

4. The CMP composition (Q) according to anyone of claims 1 to 3, wherein the specific surface area (BET) of the aluminum particles is in the range of from 20 to 90 m²/g.

5. The CMP composition (Q) according to anyone of claims 1 to 4, wherein the particle diameter d50 of the aluminum particle is in the range of from 5 to 200 nm.

6. The CMP composition (Q) according to anyone of claims 1 to 5, wherein the oxidizer comprises a peroxide.

7. The CMP composition (Q) according to anyone of claims 1 to 6, wherein the amount of oxidizer is of from 0.2 to 3 wt% based on the total weight of the CMP composition.

8. The CMP composition (Q) according to anyone of claims 1 to 7, wherein the oxidizer is hydrogen peroxide.

9. The CMP composition (Q) according to anyone of claims 1 to 8, wherein the pH value is in the range of from 3 to 5.

10. A process for the preparation of the CMP composition (Q) as defined in anyone of the claims 1 to 9 comprising, combining (A) aluminum particles, (B) oxidizer and (M) aqueous medium and adjusting the pH value to 2 to 6, thereby optionally employing a pH adjusting agent.

11. Use of the CMP composition (Q) according to anyone of claims 1 to 9 for chemical mechanical polishing of a substrate (S) used in the semiconductor industry.

12. Use according to claim 11, wherein the substrate (S) comprises
(i) elemental germanium or
(ii) Si₁₋ₓGeₓ with 0.1 ≤ x < 1.

13. Use according to claim 12 wherein the elemental germanium is grown in trenches between the STI (shallow-trench isolation) silicon dioxide.

14. A process for the manufacture of a semiconductor device comprising the chemical mechanical polishing of a substrate (S) used in the semiconductor industry in the presence of a CMP composition (Q) as defined in anyone of the claims 1 to 10.

15. A process according to claim 14, wherein the substrate (S) comprises
(i) elemental germanium or
(ii) Si₁₋ₓGeₓ with 0.1 ≤x< 1.
